# EUROPÄISCHE PATENTSCHRIFT

(11) **EP 2 439 799 B1**
(45) Veröffentlichungstag und Bekanntmachung des Hinweises auf die Patenterteilung: **15.04.2015**
(21) Anmeldenummer: 10186505.3
(22) Anmeldetag: 05.10.2010
(51) Int. Cl.: H01L 35/30, H01L 35/32

(54) **Thermoelektrischer Wandler und Wärmetauscherrohr**
Thermoelectric converter and heat exchanger tubes
Convertisseur thermoélectrique et tuyau d'échange thermique

(43) Veröffentlichungstag der Anmeldung: 11.04.2012
(73) Patentinhaber: Siemens Aktiengesellschaft, 80333 München (DE)
(72) Erfinder: Lampenscherf, Stefan Dr., 85586 Poing (DE)

(56) Entgegenhaltungen:
- EP-A1- 1 780 807
- EP-A1- 1 780 811
- EP-A2- 0 644 599
- WO-A1-2012/025476
- JP-A- 7 106 641
- JP-A- 2000 294 840
- JP-A- 2006 294 738
- US-A- 3 054 840
- US-A- 3 522 106
- US-A- 3 607 444
- US-A1- 2005 022 855
- US-A1- 2005 139 248

## Beschreibung

Die vorliegende Erfindung betrifft einen thermoelektrischen Wandler mit abwechselnd angeordneten und elektrisch miteinander verbundenen p- und n-dotierten thermoelektrischen Elementen, sowie ein Wärmetauscherrohr mit wenigstens einem solchen thermoelektrischen Wandler.

Die effiziente Wandlung von Wärmeenergie in elektrische Energie ist ein zentrales Problem der Energiewandlungstechnik. Neben der Verbesserung der großtechnisch genutzten Wärmekraftmaschinen, wie beispielsweise Gas- und Dampfturbinen, werden zunehmend auch andere Wandlungsverfahren eingesetzt, um bisher ungenutzte Wärmequellen bzw. Wärmeströme zu erschließen, wie beispielsweise die Abwärme dampferzeugender Kraftwerksanlagen. Besonders interessant sind dabei Verfahren, die sich mit einem geringen Installations- und Wartungsaufwand in den Wärmestrom bestehender Anlagen integrieren lassen. Hierzu eignen sich beispielsweise thermoelektrische Wandler bzw. thermoelektrische Generatoren der eingangs genannten Art, die nachfolgend kurz als TEGs bezeichnet werden. Mit Hilfe solcher TEGs kann Wärme unter Nutzung des so genannten Seebeck-Effekts direkt in elektrischen Strom gewandelt werden. Alternativ kann ein thermoelektrischer Wandler auch unter Nutzung des so genannten Peltier-Effekts mittels eines äußeren Stromflusses eine Änderung des Wärmetransports bewirken.

Voraussetzung für die effiziente Nutzung von TEGs ist eine gute thermische Ankopplung des TEG an die Wärmequelle bzw. Wärmesenke und damit die Erzeugung eines geeigneten Wärmestroms über den TEG. Wärmetauscherrohre in Dampfgeneratoren bieten eine gute Voraussetzung für den Einsatz von TEGs, da der Wärmestrom über die Wand der Wärmetauscherrohre im Betrieb ohne zusätzlichen Aufwand bereitgestellt wird. Derzeit existiert jedoch noch keine praktikable Lösung für die Kombination eines TEG und eines Wärmetauscherrohrs. Bisher werden fast ausschließlich planare thermoelektrische Module für den Aufbau von TEGs verwendet, da auch nur diese kommerziell erhältlich sind. Um die planaren thermoelektrischen Module thermisch ausreichend ankoppeln zu können, müssen die Wärmetauscher meist mit großem Aufwand modifiziert werden, was mit einem komplexen Aufbau und hohen Kosten einhergeht. Für die großtechnische Anwendung von TEGs in dampferzeugenden Kraftwerksanlagen ist dies allerdings keine Option.

Weitere thermoelektrische Wandler sind in den Druckschriften EP 1 780 807 A1, US 3,054,840 A, JP 7106641 A, JP 2006 294738 A, US 3,522,106 A, US 2005/139248 A1, US 2005/022855 A1, US 3,607,444 A, EP 1 780 811, WO 2012/025476 A1, JP 2000 294840 A und EP 0 644 599 A2 offenbart.

Ausgehend von diesem Stand der Technik ist es eine Aufgabe der vorliegenden Erfindung, einen thermoelektrischen Wandler der eingangs genannten Art zu schaffen, der insbesondere eine kostengünstige und wartungsfreie Kombination mit Wärmetauscherrohren ermöglicht, um eine möglichst effiziente thermisch-elektrische Energiewandlung und/oder Steuerung des Wärmeflusses über die Wärmetauscherrohre zu erreichen. Eine weitere Aufgabe der vorliegenden Erfindung besteht darin, ein entsprechendes Wärmetauscherrohr mit einem solchen thermoelektrischen Wandler bereitzustellen.

Zur Lösung der ersten Aufgabe schafft die vorliegende Erfindung einen thermoelektrischen Wandler nach Anspruch 1. Der thermoelektrische Wandler umfasst also eine alternierende Folge von p- und n-dotierten ringförmigen thermoelektrischen Elementen, die miteinander elektrisch kontaktiert sind.

Aufgrund der ringförmigen Ausbildung der thermoelektrischen Elemente können diese problemlos in Wärmetauscherrohre integriert werden, insbesondere in doppelwandig ausgebildete Wärmetauscherrohre, also solche, die eine Außenwand und eine Innenwand aufweisen.

Die geschlitzte Ausbildung ist dahingehend von Vorteil, dass eine sehr gute mechanische Stabilität unter den fertigungs- und betriebsbedingten Belastungen gewährleistet werden kann. Aufgrund der ringförmigen Ausbildung der thermoelektrischen Elemente können diese problemlos in Wärmetauscherrohre integriert werden, insbesondere in doppelwandig ausgebildete Wärmetauscherrohre, also solche, die eine Außenwand und eine Innenwand aufweisen.

Die thermoelektrischen Elemente sind durch elektrisch leitende Ringleiter elektrisch miteinander verbunden, wodurch ein besonders einfacher Aufbau erzielt wird.

Zur Lösung der eingangs genannten zweiten Aufgabe schafft die vorliegende Erfindung ein Wärmetauscherrohr mit einer Außenwand und einer von der Außenwand beabstandet angeordneten Innenwand, wobei zwischen der Außenwand und der Innenwand wenigstens ein thermoelektrischer Wandler der zuvor beschriebenen Art angeordnet ist.

Zwischen dem thermoelektrischen Wandler und der Außenwand und/oder zwischen dem thermoelektrischen Wandler und der Innenwand ist bevorzugt eine elektrisch isolierende Schicht vorgesehen.

Gemäß einer Ausgestaltung der vorliegenden Erfindung sind die thermoelektrischen Elemente des thermoelektrischen Wandlers zwischen Außenwand und Innenwand mechanisch vorgespannt, um auf diese Weise einen guten thermischen Kontakt zu gewährleisten.

Wird ein solches erfindungsgemäßes Wärmetauscherrohr beispielsweise zur Nutzung der Abwärme einer Dampfturbine eingesetzt, so entsteht während des Betriebs über den ringförmigen thermoelektrischen Elementen ein radialer Wärmestrom, der durch den Abgasstrom auf der heißen Seite und den Kühlkreislauf auf der kalten Seite angetrieben wird. Der Wärmestrom kann je nach Güte der TEGs teilweise in elektrische Energie gewandelt werden, wenn der thermoelektrische Wandler als Generator eingesetzt wird, oder durch gezielte elektrische Ansteuerung der TEGs beeinflusst bzw. geregelt werden, was zu einer Steuerung des Wärmeübergangs führt. Beim Betrieb als Generator wird in den TEGs Gleichstrom erzeugt. Dieser kann beispielsweise zur Vermeidung von Umwandlungsverlusten über einen DC/DC-Wandler direkt auf einen gemeinsamen Gleichstromzwischenkreis mit anderen Verbrauchern geleitet und beispielsweise zur Versorgung von Steuer- und Regelungstechnik im Kraftwerk genutzt werden.

Die Verwendung ringförmig ausgebildeter thermoelektrischer Elemente führt zu einer stabilen, strukturkonformen und kostengünstigen Variante bei der Kombination von Wärmetauscherrohren und TEGs.

Weitere Merkmale und Vorteile der vorliegenden Erfindung werden anhand der nachfolgenden Beschreibung einer Ausführungsform eines erfindungsgemäßen thermoelektrischen Wandlers und einer Ausführungsform eines erfindungsgemäßen Wärmetauscherrohrs unter Bezugnahme auf die beiliegende Zeichnung deutlich. Darin ist
- Figur 1: eine schematische perspektivische Ansicht eines thermoelektrischen Wandlers gemäß einer Ausführungsform der vorliegenden Erfindung;
- Figur 2: eine schematische perspektivische Ansicht eines doppelwandigen Wärmetauscherrohrs;
- Figur 3: eine schematische Schnittansicht des in Figur 2 dargestellten Wärmetauscherrohrs, in dem der in Figur 1 gezeigte thermoelektrische Wandler aufgenommen ist; und
- Figur 4: eine schematische perspektivische Ansicht des in Figur 3 dargestellten Wärmetauscherrohrs.

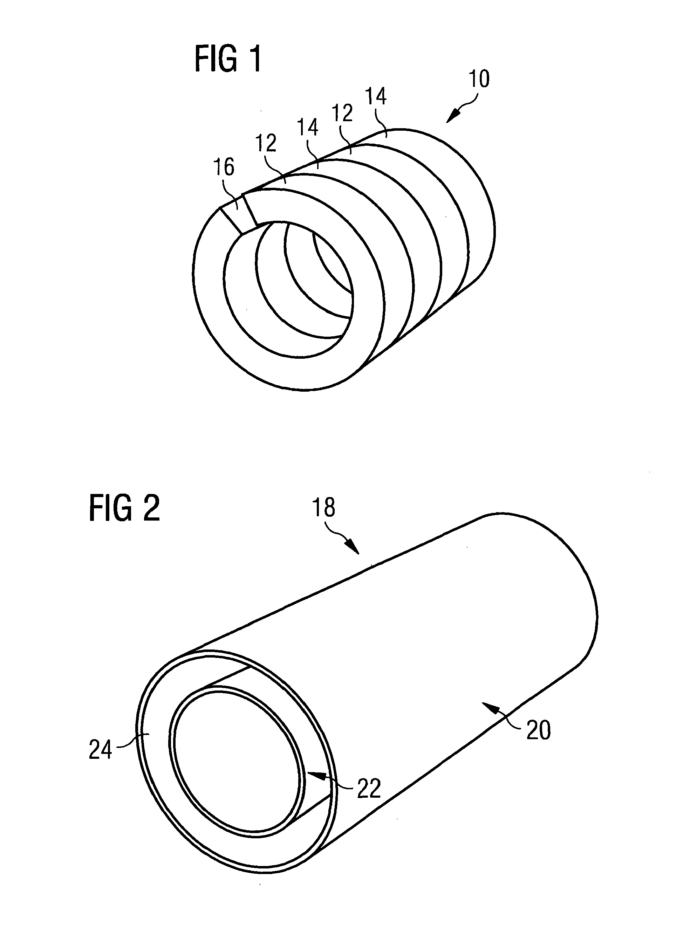

Figur 1 zeigt eine schematische Ansicht eines thermoelektrischen Wandlers bzw. eines thermoelektrischen Generators 10 gemäß einer Ausführungsform der vorliegenden Erfindung, der nachfolgend als TEG bezeichnet wird. Der TEG 10 umfasst eine Vielzahl von abwechselnd angeordneten und elektrisch miteinander verbundenen p-dotierten thermoelektrischen Elementen 12 und n-dotierten thermoelektrischen Elementen 14, von denen in Figur 1 der Einfachheit halber nur jeweils zwei dargestellt sind. Die thermoelektrischen Elemente 12 und 14 sind jeweils im Wesentlichen ringförmig ausgebildet und mit einer die Ringstruktur unterbrechenden Aussparung 16 versehen, wodurch sich eine geschlitzte Anordnung ergibt. Die geschlitzte Ausbildung der thermoelektrischen Elemente 12 und 14 dient in erster Linie der Erzeugung einer mechanischen Vorspannung in radialer Richtung, wie es nachfolgend noch näher erläutert wird.

Figur 2 zeigt ein Wärmetauscherrohr 18, das eine rohrförmige Außenwand 20 und eine rohrförmige Innenwand 22 aufweist. Die Innenwand 22 ist koaxial zur Außenwand und von dieser beabstandet angeordnet, so dass sich zwischen den beiden Wänden 20 und 22 ein ringförmiger Zwischenraum 24 erstreckt.

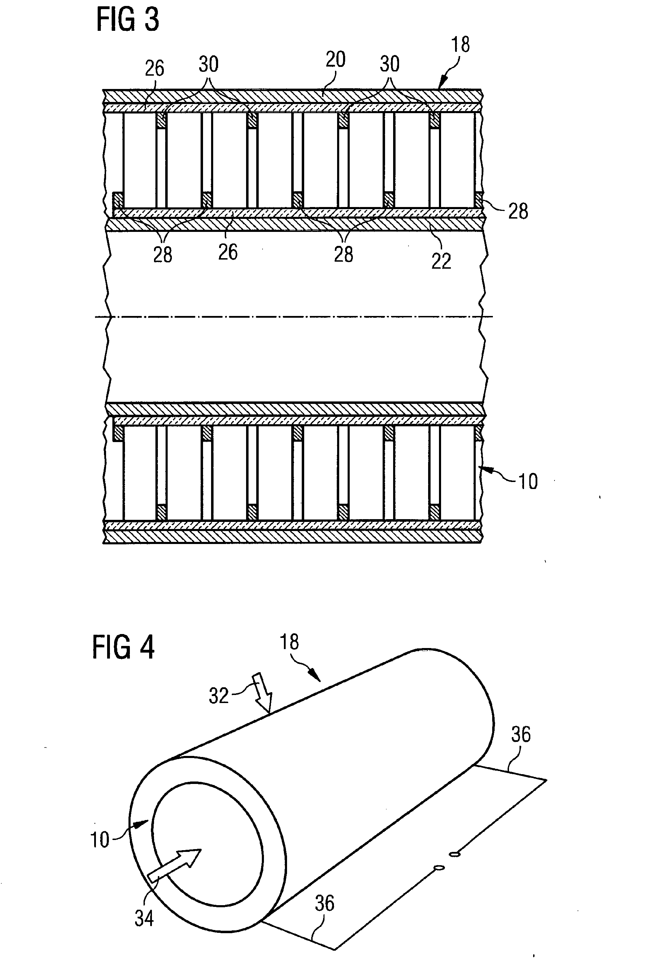

Figur 3 zeigt eine Querschnittansicht des in Figur 2 dargestellten Wärmetauscherrohrs 18, in dessen Zwischenraum 24 der in Figur 1 gezeigte TEG 10 eingesetzt ist. Zwischen dem Außenumfang des TEG 10 und dem Innenumfang der Außenwand 20 sowie zwischen dem Außenumfang der Innenwand 22 und dem Innenumfang des TEG 10 ist jeweils eine elektrisch isolierende Schicht 26 vorgesehen, um eine elektrische Trennung zwischen dem TEG 10 und dem Wärmetauscherrohr 18 herbeizuführen. Wie es in Figur 3 gut zu erkennen ist, sind die thermoelektrischen Elemente 12 und 14 jeweils durch einen elektrisch leitenden Ringleiter 28 oder 30 elektrisch miteinander verbunden, wobei sich die Ringleiter 28 und 30 im Wechsel entlang des Innenumfangs und entlang des Außenumfangs der thermoelektrischen Elemente 12 und 14 erstrecken. Auf diese Weise wird ein robuster Aufbau erzielt. Die thermoelektrischen Elemente 12 und 14 sind unter einer mechanischen Vorspannung in den zwischen der Außenwand 20 und der Innenwand 22 des Wärmetauscherrohrs 18 definierten Zwischenraum 24 eingesetzt. Diese mechanische Vorspannung wird erzielt, indem die durch die schlitzförmige Aussparung 16 erzeugten gegenüberliegenden freien Enden jedes thermoelektrischen Elementes 12 und 14 vor dem Einsetzen in den Zwischenraum 24 aufeinander zu bewegt werden, so dass sich diese im eingesetzten Zustand aufspreizen und sich entsprechend an die Außenwand 20 bzw. Innenwand 22 des Wärmetauscherrohrs 18 anlegen.

Figur 4 zeigt schematisch das Funktionsprinzip des in Figur 3 dargestellten Wärmetauscherrohrs 18, wenn dieses beispielsweise zur Nutzung der Abwärme einer Dampfturbine eingesetzt wird. Während des Betriebs entsteht über den ringförmigen thermoelektrischen Elementen 12, 14 ein radialer Wärmestrom, der durch den mit dem Pfeil 32 angedeuteten Abgasstrom auf der heißen Seite und den durch den Pfeil 34 angedeuteten Kühlkreislauf auf der kalten Seite angetrieben wird.

Wird der TEG 10 als Generator eingesetzt, so kann der Wärmestrom teilweise in elektrische Energie gewandelt werden, die über entsprechende Leiter 36 in Form von Gleichstrom abgegriffen werden kann. Dieser kann beispielsweise zur Vermeidung von Umwandlungsverlusten über einen DC/DC-Wandler direkt auf einen gemeinsamen Gleichstromzwischenkreis mit anderen Verbrauchern geleitet und dann z.B. zur Versorgung von Steuer- und Regelungstechnik im Kraftwerk genutzt werden. Alternativ kann durch eine gezielte elektrische Ansteuerung des TEG 10 über die Leiter 36 der Wärmestrom beeinflusst bzw. geregelt werden, was zu einer Steuerung des Wärmeübergangs führt.

Die Verwendung ringförmig ausgebildeter thermoelektrischer Elemente 12 und 14 führt zu einer stabilen, strukturkonformen und kostengünstigen Variante bei der Kombination des TEG 10 mit dem Wärmetauscherrohr 18.

## Patentansprüche

1. Thermoelektrischer Wandler (10) mit abwechselnd angeordneten und durch elektrisch leitende Ringleiter (28, 30) elektrisch miteinander verbundenen p- und n-dotierten thermoelektrischen Elementen (12, 14), wobei die thermoelektrischen Elemente (12, 14) im Wesentlichen ringförmig ausgebildet sind, **dadurch gekennzeichnet, dass** die ringförmigen thermoelektrischen Elemente (12, 14) jeweils mit einer einzelnen die Ringstruktur unterbrechenden Aussparung (16) versehen und entsprechend geschlitzt ausgebildet sind.

2. Wärmetauscherrohr (18) mit einer Außenwand (20) und einer von der Außenwand (20) beabstandet angeordneten Innenwand (22), **dadurch gekennzeichnet, dass** zwischen der Außenwand (20) und der Innenwand (22) wenigstens ein thermoelektrischer Wandler (10) nach Anspruch 1 angeordnet ist.

3. Wärmetauscherrohr (18) nach Anspruch 2, **dadurch gekennzeichnet, dass** zwischen dem thermoelektrischen Wandler (10) und der Außenwand (20) und/oder zwischen dem thermoelektrischen Wandler (10) und der Innenwand (22) eine elektrisch isolierende Schicht (26) vorgesehen ist.

4. Wärmetauscherrohr (18) nach Anspruch 2 oder 3, **dadurch gekennzeichnet, dass** die thermoelektrischen Elemente (12, 14) des thermoelektrischen Wandlers (10) zwischen Außenwand (20) und Innenwand (22) mechanisch vorgespannt sind.

## Claims

1. Thermoelectric transducer (10) having p-doped and n-doped thermoelectric elements (12, 14) which are arranged alternately and connected electrically to one another by means of electrically conductive annular conductors (28, 30), wherein the thermoelectric elements (12, 14) are formed essentially in the shape of a ring, **characterised in that** the ring-shaped thermoelectric elements (12, 14) are each provided with a recess (16) which individually interrupts the ring structure and embodied in an accordingly slotted manner.

2. Heat exchange pipe (18) having an outer wall (20) and an inner wall (22) arranged at a distance from the outer wall (20), **characterised in that** at least one thermoelectric transducer (10) according to claim 1 is arranged between the outer wall (20) and the inner wall (22).

3. Heat exchange pipe (18) according to claim 2, **characterised in that** an electrically insulating layer (26) is provided between the thermoelectric transducer (10) and the outer wall (20) and/or between the thermoelectric transducer (10) and the inner wall (22).

4. Heat exchange pipe (18) according to claim 2 or 3, **characterised in that** the thermoelectric elements (12, 14) of the thermoelectric transducer (10) are mechanically pretensioned between the outer wall (20) and the inner wall (22).

## Revendications

1. Convertisseur thermoélectrique (10) avec des éléments thermoélectriques (12, 14) à dopage p et n reliés électriquement entre eux disposés à tour de rôle et par le biais de conducteurs annulaires électriquement conducteurs (28, 30), dans lequel les éléments thermoélectriques (12, 14) sont réalisés pour l'essentiel en forme d'anneau, **caractérisé en ce que** les éléments thermoélectriques annulaires (12, 14) sont pourvus respectivement d'un évidement unique (16) interrompant la structure annulaire et réalisés de manière correspondante avec une fente.

2. Tube d'échange thermique (18) avec une paroi extérieure (20) et une paroi intérieure (22) disposée à distance de la paroi extérieure (20), **caractérisé en ce que**, entre la paroi extérieure (20) et la paroi intérieure (22), au moins un convertisseur thermoélectrique (10) selon la revendication 1 est agencé.

3. Tube d'échange thermique (18) selon la revendication 2, **caractérisé en ce que**, entre le convertisseur thermoélectrique (10) et la paroi extérieure (20) et/ou entre le convertisseur thermoélectrique (10) et la paroi intérieure (22), est prévue une couche électriquement isolante (26).

4. Tube d'échange thermique (18) selon la revendication 2 ou 3, **caractérisé en ce que** les éléments thermoélectriques (12, 14) du convertisseur thermoélectrique (10) sont précontraints mécaniquement entre la paroi extérieure (20) et la paroi intérieure (22).
